Europäisches Patentamt

European Patent Office

Office européen des brevets

(19)

(11) Publication number: **0 256 428 B1**

(12) **EUROPEAN PATENT SPECIFICATION**

(45) Date of publication of patent specification: **11.11.92**

(51) Int. Cl.5: **H05K 3/10**, C23C 18/16, B29C 45/16

(21) Application number: **87111292.6**

(22) Date of filing: **05.08.87**

(54) **Molded metallized plastic articles and processes for making the same.**

(30) Priority: **15.08.86 US 897298**

(43) Date of publication of application:
**24.02.88 Bulletin  88/08**

(45) Publication of the grant of the patent:
**11.11.92 Bulletin  92/46**

(84) Designated Contracting States:
**AT CH FR IT LI NL SE**

(56) References cited:
**EP-A- 0 140 304**
**EP-A- 0 192 233**
**GB-A- 1 254 308**

(73) Proprietor: **AMP-AKZO CORPORATION (a Delaware corp.)**
**710 Dawson Drive**
**Newark, Delaware 197113(US)**

Proprietor: **SMITH CORONA CORPORATION**
**65 Locaust Avenue**
**New Canaan, CT 06840(US)**

(72) Inventor: **Cleveland, Eric J.**
**25 Cayuga Street**
**Homer, NY 13077(US)**
Inventor: **Frisch, David C.**
**476 Seaman Avenue**
**Baldwin, NY 11510(US)**

(74) Representative: **Königseder-Egerer, Claudia**
**Zugspitzstrasse 65**
**W-8104 Grainau(DE)**

# Description

This invention relates to processes for forming plastic articles with metallic patterns on their surfaces, e.g. molded, one-piece blanks for printed circuit boards and molded, metallized one-piece articles such as printed wiring boards. The processes include two separate molding steps to form portions of the articles.

In EP-A 0 192 233 (Application No. 86102055.0), falling within the terms of Article 54, paragraph 3, a method for forming a molded article for adherent metallization, such as a printed circuit board, has been suggested using a two-shot injection molding process which includes forming a first predetermined shape, such as a circuit pattern for a printed circuit board, by injection molding a first shot of electrically insulating material into a first mold cavity, integrating said first shape into a second cavity, and forming a second predetermined shape by injection molding a second shot of electrically insulating material into said second mold cavity.

The article is removed from the second mold cavity and processed by an additive process to add metal on exposed surface areas of said first predetermined shape. In the above copending application it is further suggested to use as a first electrically insulating material one which is treatable to add metal thereto with strong adhesion, and as a second insulating material one which avoids metal adherence leaving it to a costly trial and error approach for selecting the two insulating materials, and frequently indiscriminate metal deposition was experienced.

GB-A-1 254 308 discloses a process for the manufacture of a selectively metal-plated plastics moulding, which comprises forming an article by a 2-shot injection or compression-moulding process using a plateable plastics material and an unplateable plastics material, the arrangement of the mould and the order of the shots being such that those portions of the composite article which it is desired to plate are formed of the plateable plastics material, and subjecting the article to a plating process.

It is an object of this invention to form a molded article for adherent metallization, such as a printed circuit board with a circuit pattern, by a process which eliminates the problems caused by indiscriminate metal deposition.

A further object of this invention is to eliminate the trial and error procedure for selecting the electrically insulating materials for the first and second predetermined shapes. Molded printed circuits with three dimensional surface features and non-planar molded circuits with non-planar conductor patterns are among the metallized polymer articles that may be produced by the process of the invention.

Other object, features and advantages of the invention will become more apparent from the following description including appended claims.

The process of this invention for forming a plastic article with a metallic pattern on its surface comprises using an amorphous thermoplastic resin compound to form at least one first insulating shape; using a crystalline thermoplastic resin compound to form at least one second insulating shape around said first shape making an unitary article having exposed on its surface predetermined areas consisting of the first shape surrounded by areas consisting of the second shape; treating the unitary article to adhesion promote only the exposed surface areas composed of the amorphous resin compound of the first shape; and depositing metal on the surface portions of the unitary article composed of the first shape; wherein the crystalline thermoplastic resin compound is selected from the group consisting of polyester, polyphenylene sulfide, polyetheretherketone, polyvinylchloride, polyethylene and polypropylene resins and combinations thereof.

In another embodiment, the process for forming a plastic article with a metallic pattern on its surface comprises using a crystalline thermoplastic resin compound to form at least one first insulating shape; using an amorphous thermoplastic resin compound to form at least one second insulating shape around said first shape making an unitary article having exposed on its surface predetermined areas consisting of the first shape surrounded by areas consisting of the second shape; wherein the crystalline thermoplastic resin compound is selected from the group consisting of polyester, polyphenylene sulfide, polyetheretherketone, polyvinylchloride, polyethylene and polypropylene resins and combinations thereof; treating the unitary article to adhesion promote only the exposed surface areas composed of the amorphous resin compound of the second shape; and depositing metal on the surface portions of the unitary article composed of the second shape.

It has been discovered that a polymer article with an adherent metallic surface pattern may be formed by a two-shot molding technique in which one molding shot utilizes a crystalline polymer resin and the other molding shot utilizes an amorphous polymer resin. The surface areas of the article which are to have a metallic area thereon are formed of the amorphous polymer resin, and the surface areas of the article which will not have metal thereon are formed of the crystalline polymer resin. The article formed by the two-shot molding is adhesion promoted by conventional treatment techniques such as exposing the surface ares to strong oxidizers or to a solvent followed by strong oxidizers. The portion of the surface formed of amorphous polymer resin is made hydrophilic and receptive to adherent metallization by the adhesion promoting treatment. The portion of the surface formed of crystalline polymer resin is substantially unaffected by the adhesion promoting treatment and remains hydrophobic and resistant to adherent metallization. Metallization is accomplished by conventional techniques such as activation and electroless plating. By amorphous thermoplastic resins or polymers'are meant thermoplastic resins whose mechanical properties decrease at a relatively modest rate with increasing temperature until the onset of their glass transition. The temperature of the onset of glass transition marks the limit of their ability to bear continuous load and to remain dimensionally stable. Suitable amorphous resins include those listed with a $T_g$ (amorphous) in the "Resins and Compounds" Property Chart, Modern Plastics Encyclopedia 1985-1986, Vol. 62, No. 10A, Oct. 1985, McGraw Hill Inc., New York, p. 448 et seq.

By 'crystalline thermoplastic polymers or resins" are meant thermoplastic resins which have the ability to retain significant mechanical properties above their glass transition temperature range. This is due to their crystalline bonds and the fact that the crystalline melt ing point of a polymer always is substantially higher than its glass transition. Among the crystalline resins are those listed with a $T_m$ - (crystalline) in the "Resins and Compounds" Property Chart, Modern Plastics Encyclopedia 1985-1986, supra.

In one aspect, this invention concerns an improved method of making a plastic insulating body with a conductive metal pattern adhered to its surface. The plastic insulating body is preferably made with two or more insulating resin compounds by a two-shot or insert molding technique. Individual conductors of the conductive pattern are insulated from each other and from other conductors by the insulating resin compounds used in both molding shots. In order to form the conductive metal pattern on the surface of the plastic body and adhering thereto, the plastic insulating body is molded with the portion of its surface to be metallized comprising a first insulating resin compound, and the portion of its surface to be disposed around the metal portion of the pattern comprising a second insulating resin compound. The resin compounds are selected so that the portion of the surface comprising the first insulating resin compound may be adhesion promoted and made hydrophilic by an adhesion promoting process, and the portion of the surface comprising the second insulating resin compound is hydrophobic and not affected by the adhesion promotion process, or can be made hydrophobic during the metallization process.

The invention enables the manufacture of three dimensional bases for printed circuits where the surface conductor features are not confined to planar surfaces, but can comprise any three dimensional features which can be mold.

It has been discovered that amorphous polymer resins may be adhesion promoted for adherent metal deposition by known chemical oxidizing systems. Surprisingly, it has also been discovered that crystalline polymer resins are resistant to the chemical oxidizing systems used to adhesion promote surfaces consisting of amorphous polymers. The surfaces consisting of crystalline resins remain hydrophobic , while surfaces consisting of amorphous resins are easily adhesion promoted and made hydrophilic. Among the chemical oxidizing systems used to adhesion promote polymeric surfaces are plasma systems or oxidizing solutions of chromic acid or of permanganates. Frequently, a solvent or a solvent mixed with water is used as a pretreatment for the plastic surface before it is treated with the oxidizing solution, which makes it hydrophilic.

A suitable method of forming the conductive metal pattern on the adhesion promoted portion of the surface is by electroless metal deposition.

In an example of the invention, a plastic insulating body is molded with the first molding shot, the first insulating resin compound being an amorphous thermoplastic resin containing a catalyst for electroless metal deposition, and the second molding shot being a second insulating resin compound which is a crystalline thermoplastic resin. Fillers for the amorphous thermoplastic resin may be treated with catalysts for electroless metal deposition.

It is well known that crystalline polymers are only partially crystalline. X-ray results show conclusively that crystalline regions in polymers extend no more than a few hundred angstrom units even in the direction of the polymer chains. Since polymer molecules when completely extended (as they are in the crystals) are several times this length, the crystals can contain only section of molecules. The polymer molecules pass successively through several crystalline and amorphous regions. Most crystalline polymers are estimated to be 50 to 75% crystalline, although some are known to be 75 to 85% crystalline. When using an injection molding process with an amorphous resin for one shot and a crystalline resin for another shot according to the invention, the amorphous and crystalline resins selected should join together when molded to form a single self adherent unit. It has been discovered that the bond joining the second shot resin is improved by preheating the first shot insert to a temperature just under the onset of glass transition, $T_g$,for amorphous thermoplastic inserts, or just under the crystalline melting temperature, $T_m$, for crystalline thermoplastic inserts. The inserts are heated to 20° to 80°C below the $T_g$ or $T_m$, preferably 40° to 70°C below $T_g$ or $T_m$

It has also been discovered that the injection time for the second shot should be less than 0.5 seconds, and preferably less than 0.3 seconds in order to get optimum adhesion and filling of the mold.

To improve the adherence between dissimilar resins in the first and second shot, the first shot mold can be textured at the areas which will be in contact with the second shot. The mold walls would not be textured in areas corresponding to portions of the first shot which will form part of the surface of the molded plastic insulating base. All surfaces that will be adhesion promoted are preferably polished or smooth in order to achieve a smooth metal coating thereon.

Surfaces of second shot molding which are not to be plated should be highly polished to provide a smooth, hydrophobic surface that resists extraneous metal deposition.

An amorphous engineering polymer which is easily adhesion promoted is preferably selected for the surfaces to be metallized, and a crystalline engineering polymer which is hydrophobic and resistant to adhesion promotion is preferably selected for the surfaces which are not to be metallized. A crystalline polymer is not completely crystalline. It contains both crystalline and amorphous portions. The amount of crystallinity depends to some extent on the molding temperature and molding cycle. The crystallinity can be decreased by additives, plasticizers, polymer blending or alloying, copolymerization, and side chains on the resin molecule. By increasind the amorphous character of a crystalline resin, the same generic resin can be used for both moldings, a resin with a high percentage of amorphous character for the molding to be adhesion promoted and metallized, and a similar resin with a high percentage of crystallinity for the hydrophobic molding which is resistant to adhesion promotion. Good adhesion between the two moldings is insured by using the same generic resin for both moldings.

The resins can be provided with fillers for reinforcement and with colorants. It is preferred to add a filler catalytic for electroless metal deposition to the amorphous resin, or the resin whose surface is to be plated.

The catalytic filler may be 0.5 %, preferably 3 to 15%, based on the thermoplastic resin. Fillers containing trace amounts of iron, and some colorants containing carbon black and copper phthalocyanine pigments should be avoided in the crystalline resin which is not to be metallized. The said fillers and colorant sometimes catalyze extraneous electroless metal deposition on the hydrophobic resin surface.

Especially suitable as insulating materials for the circuit pattern are the non-crystalline, amorphous thermoplastics. The amorphous thermoplastics are preferred for the circuit pattern because they can be adhesion promoted for adherent electroless metal deposition by treatment with aqueous solutions of strong oxidizers such as chromic acid or permanganate, or by the swell and etch technique which uses a solvent treatment to enhance the action of the oxidizers. Among the amorphous, high temperature, thermoplastic materials useful for this invention are polyetherimides, and the sulfone resins, polysulfone, polyarylsulfone and polyethersulfone. These resins are in the group known as engineering plastics. Other suitable amorphous resins with lower service temperature include ABS (acrylonitrile-butadiene-styrene copolemers). The plateable grades of ABS can be adhesion promoted without a solvent swell.

Particularly preferred materials for the second insulating material are the crystalline, high temperature, thermoplastic resins polyphenylene sulfide and polyetheretherketone which are hydrophobic and not affected by the adhesion promotion techniques used to adhesion promote the amorphous resins preferred for the first insulating material. These high temperature resins are also in the group known as engineering plastics. Suitable crystalline resins for low temperature service which are unaffected by the processes used to adhesion promote amorphous resins of the first shot are polyvinyl chloride, polyethylene and polypropylene.

In injection molding thermoplastics, it is standard practice to dry the resin before molding. To practice this invention by injection molding, it has been found that the drying process is more critical for water vapor than most molding processes, and even more critical than normal for engineering plastic molding. Requirements are more stringent than normal practice where the primary attribute of the finished molding is its appearance. Traces of moisture remaining in the resin used to make the first shot will make the part stressed and porous, and when the second shot is molded, the heating of the first shot will be uneven due to the porous portions of the insert. The result will be poor filling of the mold by the second shot due to temperature variations. Moisture in the second shot resin will also induce stress, poor bonding between the first and second shot, and impede the filling of the mold due to expansion of the water vapor with heat. Attempts to overcome traces of moisture in the second shot resin require more heat or more pressure and result in distorting the insert. Further, the stresses induced by traces of water in the resin affect the post molding adhesion promotion and plating processes.

One method of adequately driving off moisture from the engineering plastic resins is to heat the resin to 120° to 170°C for three to four hours. In addition to the standard practice which requires the operating temperature of the drier to be 120° to 170°C, it is necessary to measure the temperature at many points in the resin batch not only the center but also the edges, and insure that all portions of the resin are at drying temperature. The first shot molding or insert is preheated before it is inserted into the second shot mold. The preheat temperature is preferably below the glass transition temperature of an amorphous resin, or below the heat distortion temperature of a crystalline resin. If the temperature of the insert is too low, there will be voids in the second shot and poor adhesion leading to separation between the first and second moldings.

The injection molding press and the gating of the mold should be selected to fill the second shot mold in less than 1 second, preferably in less than 0.5 second, and more preferably in less than 0.3 second.The optimum molding temperature for adherence of the second shot to the first shot insert is in a narrow range. If the mold is not filled in under 0.5 seconds, it is difficult to achieve good temperature control and good adherence. If the temperature is controlled by raising the mold temperature instead of filling the mold faster, there is a danger of softening the insert and moving the surface features of the insert out of position.

The molded article is stress relieved by placing it in an oven; raising the oven temperature to 200°C; holding the article at temperature for four hours; and then cooling the article in the oven.

After the article is stress relieved, it is adhesion promoted by a prior art swell and etch procedure comprising immersion in a solution of 90% dimethylformamide and 10% water and etching in an aqueous chromic/sulfuric acid solution. After neutralization, the desired metal pattern is formed by a prior art process of electroless metal deposition.

The preferred electroless copper plating solution solution comprises 0.05 mol/l copper, 0.08 mol/l ethylenediamine-tetra-2-propanol, 0.05 mol/l formaldehyde, 0.0009 mol/l alkylphenoxyglycidolphosphate ester (Gafac RE 610®), 0.0002 mol/l sodium cyanide (by specific ion electrode), 0.007 mol/l potassium selenocyanate, and alkali metal hydroxide to pH of 12.8 at 25°C. The copper plating is uniform and free of breaks or pin holes and no copper is deposited on the smooth shiny surface of the crystalline material.

EXAMPLE

A two-shot molded printed circuit base was prepared by the following procedure:

The first shot was molded of an amorphous thermoplastic resin compound containing a catalyst for electroless metal deposition. The thermoplastic was a polyarylsulfone resin (Radel PXM® 85113) containing 3% of a clay filler treated with 1100 ppm palladium (Cat 10®). This was molded with elevated surface features corresponding to the areas which were to be metallized to form a printed circuit.

Before molding the polyarylsulfone resin it was dried for four hours at 120°C.

The first shot was molded in a horizontal 100 ton injection molding machine with a 142 g barrel. This first shot including the runner and sprue, weighed 7.6 g, and without the runner and sprue, it weighed 3.2 g. The barrel temperatures were: rear zone 350°C, center zone 360°C, front zone 360°C and nozzle 365°C. The mold temperature was 120°C and the injection pressure 90 MPa; there was no back pressure. The injection time was 0.5 seconds, the holding pressure 40 MPa and the holding time 1.8 seconds. The cure time was 12 seconds.

The second shot was molded around the first shot not covering the elevated surface features. A crystalline thermoplastic resin compound, polyphenylene sulfide (Ryton R-4®) was used for the second shot. The second shot weighed 19.7 g, including the runner and sprue, but not including the first shot insert, and 14.9 g excluding the runner and sprue without the insert, and 18.1 g with the insert.

Before molding the second shot, the polyphenylene sulfide resin compound was dried for three hours at 120°C. The first shot insert was heated to 150°C before loading it into the mold for the second shot. The barrel temperatures for the second shot were: rear zone 255°C, center zone, front zone and nozzle 260°C. The mold temperature was 135°C and the injection pressure 97 MPa; there was no back pressure. The injection time was 0.01 seconds, the holding pressure 44 MPa and the holding time 8 seconds. The cure time was 15 seconds.

This produced a mold plastic base with a surface pattern of amorphous polyarylsulfone corresponding to the desired metal conductor pattern, and crystalline polyphenylene sulfide corresponding to the desired surface insulating pattern.

The amorphous polyarylsulfone portion of the surface was adhesion promoted. The crystalline polyphenylene sulfide resin was unaffected by the adhesion promition process. The adhesion promotion exposed the catalytic filler in the amorphous resin surface, and the amorphous resin sur face was electrolessly plated with copper using the preferred plating solution mentioned hereinbefore. A layer of 25 μm of copper was deposited on the adhesion promoted amorphous resin surface and no copper on the crystalline resin surface.

## Claims

1. A process for forming a plastic article with a metallic pattern on its surface comprising using an amorphous thermoplastic resin compound to form at least one first insulating shape; using a crystalline thermoplastic resin compound to form at least one second insulating shape around said first shape making an unitary article having exposed on its surface predetermined areas consisting of the first shape surrounded by areas consisting of the second shape; treating the unitary article to adhesion promote only the exposed surface areas composed of the amorphous resin compound of the first shape; and depositing metal on the surface portions of the unitary article composed of the first shape; wherein the crystalline thermoplastic resin compound is selected from the group consisting of polyester, polyphenylene sulfide, polyetheretherketone, polyvinylchloride, polyethylene and polypropylene resins and combinations thereof.

2. A process for forming a plastic article with a metallic pattern on its surface comprising using a crystalline thermoplastic resin compound to form at least one first insulating shape ; using an amorphous thermoplastic resin compound to form at least one second insulating shape around said first shape making an unitary article having exposed on its surface predetermined areas consisting of the first shape surrounded by areas consisting of the second shape; wherein the crystalline thermoplastic resin compound is selected from the group consisting of polyester, polyphenylene sulfide, polyetheretherketone, polyvinylchloride, polyethylene and polypropylene resins and combinations thereof; treating the unitary article to adhesion promote only the exposed surface areas composed of the amorphous resin compound of the second shape; and depositing metal on the surface portions of the unitary article composed of the second shape.

3. The process of claims 1 or 2 wherein the metal is deposited by electroless metal deposition.

4. The process of claims 1 or 2 wherein the amorphous thermoplastic resin compound contains a catalyst for electroless metal deposition.

5. The process of claims 1 or 2 wherein the amorphous thermoplastic resin compound is selected from the group consisting of polysulfone, polyethersulfone, polyarylsulfone, polyetherimide and acrylonitrile-butadiene-styrene copolymer resins and combinations thereof.

6. The process of claims 1 and 2 wherein the second insulating shape is formed on the first insulating shape by an injection molding process.

7. The process of claims 1 and 2 wherein the first insulating shape is formed by injection molding.

8. The process of claims 1 and 7 wherein the first insulating shape is preheated to a temperature just below the onset of glass transition before molding the second insulating shape around it.

9. The process of claims 1 and 7 wherein the first insulating shape is preheated to a temperature 200 to 80°C below the crystalline melting temperature before molding on the second insulating shape.

10. The process of claims 6 or 7 wherein the injection time for the injection molding process of the crystalline insulating material is less than 0.5 seconds, and preferably less than 0.3 seconds.

## Patentansprüche

1. Ein Verfahren zum Herstellen eines Kunststoffartikels mit einem Metallmuster auf seiner Oberfläche unter Verwendung einer amorphen thermoplastischen Harzverbindung zum Herstellen wenigstens einer Isolierstoff-Form; unter Verwendung einer kristallinen thermoplastischen Harzverbindung zum Herstellen wenigstens einer zweiten Isolierstoff-Form, die die erste Form umschließt und mit dieser einen einheitlichen Körper bildet, auf dessen Oberfläche vorbestimmte Bezirke freiliegen, die aus der ersten Form, umgeben von Bezirken der zweiten Form bestehen; Behandeln des einheitlichen Körpers zur Verbesserung der Haftfestigkeit nur der aus der amorphen Harzmischung bestehenden Oberflächenbezirke der ersten Form; und Abscheiden von Metall auf den Oberflächenbezirken des einheitlichen Körpers, die aus der ersten Form bestehen; wobei die kristalline thermoplastische Harzmischung ausgewählt ist aus der Gruppe bestehend aus Polyester-, Polyphenylensulfid- Polyetheretherketon-, Polyvinylchlorid-, Polyethylen- und Polypropylenharzen und Mischungen von diesen.

2. Ein Verfahren zum Herstellen eines Kunststoffartikels mit einem Metallmuster auf seiner Oberfläche unter Verwendung einer kristallinen thermoplastischen Harzverbindung zum Herstellen wenigstens einer Isolierstoff-Form; unter Verwendung einer amorphen thermoplastischen Harzverbindung zum Herstellen wenigstens einer zweiten Isolierstoff-Form, die die erste Form umschließt und mit dieser einen einheitlichen Körper bildet, auf dessen Oberfläche vorbestimmte Bezirke freiliegen, die aus der ersten Form, umgeben von Bezirken der zweiten Form bestehen; wobei die kristalline thermoplastische Harzmischung ausgewählt ist aus der Gruppe bestehend aus Polyester-, Polyphenylensulfid- Polyetheretherketon-, Polyvinylchlorid-, Polyethylen- und Polypropylenharzen und Mischungen von diesen; Behandeln des einheitlichen Körpers zur Verbesserung der Haftfestigkeit nur der aus der amorphen Harzmischung bestehenden Oberflächenbezirke der Zweiten Form; und Abscheiden von Metall auf den Oberflächenbezirken des einheitlichen Körpers, die aus der zweiten Form bestehen.

3. Das Verfahren nach den Ansprüchen 1 oder 2, bei dem das Metall in einem stromlosen Metallabscheidungsverfahren aufgebracht wird.

4. Das Verfahren nach den Ansprüchen 1 oder 2, bei dem die amorphe thermoplastische Harzverbindung einen auf die stromlose Metallabscheidung katalytisch wirkenden Zusatz enthält.

5. Das Verfahren nach den Ansprüchen 1 oder 2, bei dem die amorphe thermoplastische Harzmischung ausgewählt ist aus einer Gruppe, die Polysulfon-, Polyethersulfon-, Polyarylsulfon-, Polyetherimid- und Akrylonitrilbutadienstyrencopolymer-Harze und Mischungen von diesen, enthält.

6. Das Verfahren nach den Ansprüchen 1 und 2, bei dem die zweite Isolierstoff-Form um die erste Isolierstoff-Form herum in einem Spritzgußverfahren hergestellt wird.

7. Das Verfahren nach den Ansprüchen 1 oder 2, bei dem die erste Isolierstoff-Form im Spritzgußverfahren hergestellt wird.

8. Das Verfahren nach den Ansprüchen 1 und 7, bei dem die erste Isolierstoff-Form auf eine Temperatur vorgeheizt wird, die gerade unterhalb des Einsetzens der Umwandlung in den glasartigen Zustand liegt, bevor die zweite Isolierstoff-Form um die erste Form herum geformt wird.

9. Das Verfahren nach den Ansprüchen 1 und 7, bei dem die erste Isolierstoff-Form auf eine Temperatur vorgeheizt wird, die 20° bis 80°C unterhalb der kristallinen Schmelztemperatur liegt, bevor sie um die zweite Isolierstoff-Form geformt wird.

10. Das Verfahren nach den Ansprüchen 6 oder 7, bei dem die Spritzzeit des Spritzgußverfahrens des kristallinen Isolierstoffmaterials weniger als 0,5 Sekunden, und vorzugsweise weniger als 0,3 Sekunden beträgt.

**Revendications**

1. Procédé destiné à former un article plastique comportant une configuration métallique sur sa surface, consistant à utiliser une résine thermoplastique amorphe pour former au moins un premier moulage isolant ; à utiliser une résine thermoplastique cristalline pour former au moins un deuxième moulage isolant autour dudit premier moulage de façon à réaliser un article unitaire sur la surface duquel se trouvent exposées des zones prédéterminées constituées du premier moulage entourées de zones constituées du deuxième moulage ; à traiter l'article unitaire de façon à ne faire subir une activation d'adhérence qu'aux zones superficielles exposées constituées de la résine amorphe du premier moulage ; et à déposer un métal sur les portions de surface de l'article unitaire constituées du premier moulage ; la résine thermoplastique cristalline étant choisie parmi l'ensemble comprenant les résines de polyester, de poly(sulfure de phénylène), de polyéther-éthercétone, de poly(chlorure de vinyle), de polyéthylène et de polypropylène, et leurs mélanges.

2. Procédé destiné au formage d'un article plastique ayant sur sa surface une configuration métallique consistant à utiliser une résine thermoplastique cristalline pour former au moins un premier moulage isolant ; à utiliser une résine thermoplastique amorphe pour former au moins un deuxième moulage isolant autour dudit premier moulage, de façon à réaliser un article unitaire sur la surface duquel sont exposées des zones prédéterminées constituées du premier moulage entourées de zones constituées du deuxième moulage ; dans lequel la résine thermoplastique cristalline est choisie dans l'ensemble comprenant les résines de polyester, de poly(sulfure de phénylène), de polyéther-éthercétone, de poly(chlorure de vinyle), de polyéthylène et de polypropylène, et leurs combinaisons ; à traiter l'article unitaire de façon à ne faire subir une activation d'adhérence qu'aux zones superficielles exposées constituées de la résine amorphe du deuxième moulage ; et à déposer un métal sur les portions de surface de l'article unitaire constituées du deuxième moulage.

3. Procédé selon les revendications 1 ou 2, dans lequel le métal est déposé par métallisation autocatalytique.

4. Procédé selon les revendications 1 ou 2, dans lequel la résine thermoplastique amorphe contient un catalyseur de la métallisation autocatalytique.

5. Procédé selon les revendications 1 ou 2, dans lequel la résine thermoplastique amorphe est choisie parmi l'ensemble comprenant les résines de polysulfone, de polyéthersulfone, de polyarylsulfone, de polyétherimide et du copolymère acrylonitrile-butadiène-styrène et leurs combinaisons.

6. Procédé selon les revendications 1 et 2, dans lequel le deuxième moulage isolant est formé sur le premier moulage isolant par une technique de moulage par injection.

7. Procédé selon les revendications 1 et 2, dans lequel le premier moulage isolant est formé par moulage par injection.

8. Procédé selon les revendications 1 à 7, dans lequel le premier moulage isolant est préchauffé à une température juste en-dessous de l'apparition de la transition vitreuse avant moulage, autour de lui, du deuxième moulage isolant.

9. Procédé selon les revendications 1 et 7, dans lequel le premier moulage isolant est préchauffé à une température de 20 à 80°C inférieure à la température de fusion cristalline avant moulage sur le deuxième moulage isolant.

10. Procédé selon les revendications 6 ou 7, dans lequel le temps d'injection, pour le procédé de moulage par injection du matériau isolant cristallin, est inférieur à 0,5 seconde et de préférence inférieur à 0,3 seconde.